# EUROPEAN PATENT SPECIFICATION

(11) **EP 0 365 807 B1**
(45) Date of publication and mention of the grant of the patent: **22.12.1993**
(21) Application number: 89116815.5
(22) Date of filing: 12.09.1989
(51) Int. Cl.: B23K 35/26, B23K 35/00

(54) **Bonding of metallic surfaces**
Verbinden von metallischen Oberflächen
Soudage de surfaces métalliques

(30) Priority: 12.10.1988 US 256534
(43) Date of publication of application: 02.05.1990
(73) Proprietor: International Business Machines Corporation, Armonk, N.Y. 10504 (US)
(72) Inventor: Wilcox, James Robert, Vestal New York 13850 (US); Woychik, Charles Gerard, Endicott New York 13760 (US)
(74) Representative: Schäfer, Wolfgang, Dipl.-Ing.

(56) References cited:
- FR-A- 2 006 737
- FR-A- 2 460 176
- GB-A- 1 204 052
- US-A- 3 417 461
- US-A- 3 496 630
- US-A- 4 767 471
- IBM TECHNICAL DISCLOSURE BULLETIN, vol. 16, no. 9, February 1974, page 2900; E. DIONNE et al.: "Method for modified solder reflow chip joining"
- Brazing by the Diffusion-Controlled Formation of a Liquid Intermediate Phase, Lynch, Feinstein, Huggins, Welding Research Supplement,Feb 1959
- Study of the TLP Bonding. Process applied to a Ag/Cu/Ag Sandwich Joint, Tuah-Poku, Dollar, Massalski, Metallurgical Transactions, vol. 19A, March 1988

## Description

The present invention is concerned with a method for bonding metallic surfaces together and is especially concerned with a method that does not require flux. The method of the present invention is concerned with a process for bonding metallic surfaces whereby different metals of a eutectic system are deposited on the surfaces to be bonded and the metals are then contacted at a temperature above the eutectic temperature. The process of the present invention is especially suitable for bonding metallic terminals, such as copper terminals, on electronic components such as semiconductor chips, semiconductor chip carrying modules, surface mounted electronic devices, and the like, to copper pads on a second level electronic package such as a printed circuit board or a printed circuit card.

In many products and applications it becomes necessary to bond two metallic surfaces together. For instance, in the fabrication of current day electronic devices, it is necessary to bond electrically conductive metallic bonding pads, such as copper bonding pads, together. For instance, the copper terminals on an electronic component such as a semiconductor chip, a semiconductor chip carrying module, or a surface mounted electronic device needs to be bonded to a corresponding copper bonding pad on a second level electronic package such as a printed circuit board or a printed circuit card. The techniques generally employed are conventional surface soldering techniques which normally require that a solder or solder paste be provided in the desired locations for bonding as well as providing solder flux for the soldering operation. In addition, the use of conventional soldering techniques are undesirable because of the potential for solder bridging between closely spaced adjacent pads (i.e., electrical shorting of two adjacent pads with solder).

More recently a technique for bonding two metallic surfaces together referred to as "transient liquid phase" has been suggested. In particular, "transient liquid phase bonding" involves depositing different metals of a eutectic system on the metallic surfaces to be bonded. These depositions are contacted at a temperature above the eutectic temperature. Interdiffusion between the two eutectic components produces a thin, liquid layer that has a composition range which corresponds to the liquid phase region of the eutectic phase diagram. Solidification of this thin, liquid region bonds the metallic surfaces together. As compared to conventional surface soldering techniques, a transient liquid phase bonding process has several advantages such as confining the liquid metal phase region to the contacting area of the mating substrates. Also, the minimum spacing between substrates is not restricted by the resolution of a solder paste screening process or by concerns of solder bridging. This, in turn, makes it possible to provide for much greater area densities of contacted metal surfaces.

An especially significant problem exists with bonding of copper surfaces together with lead-tin solders in that the formation of excessive copper-tin intermetallics tends to adversely affect the mechanical strength of the bonds. With respect to a transient liquid phase bonding technique, solidifying the liquid zone before it reaches the copper would avoid this formation of excessive intermetallic compounds and, thus, provide for improved mechanical strength of the bond.

Notwithstanding the numerous advantages achievable by employing a transient liquid phase bonding technique, there exist certain difficulties with respect to adequately implementing the process. For instance, the surfaces to be bonded must be in intimate contact with each other, which requires smooth, planar oxide-free surfaces in order to provide the necessary metal-to-metal contact at all points. For instance, components that are not bonded shortly after deposition of the metal will form an oxide layer which may then act as a barrier to diffusion and thereby prevent the desired bonding. This illustrates the need for time constraints on the storage of coated metallic substrates that are to be bonded prior to the bonding procedure and/or the need for removal of oxide layers.

In order to compensate for inevitable surface roughness, the suggested transient liquid phase bonding must be conducted under an applied pressure to assure that the surfaces to be bonded have the necessary intimate contact. Thus, such a bonding technique is restricted to those components in which the bonding surfaces can be compressed and it precludes the use of leadless components, unless the component itself can withstand the bonding pressure.

Also, since the initial liquid zone forms at a very rapid rate during the bonding, controlled solidification is very difficult to properly effect. For instance, with conventional heating or reflow procedures, the liquid zone generally consumes both coating layers on the metallic substrates.

The present invention is given in claim 1 and is concerned with a process for bonding two metallic surfaces together which can be carried out without flux, without the formation of excessive intermetallic phases, and reducing the possibility of solder bridging.

In particular, the process of the present invention is concerned with an improved "transient liquid phase bonding" process.

The present invention overcomes both the above-discussed problems with respect to normal transient liquid phase bonding techniques while, at the same time, retaining the advantages of such a technique over conventional surface soldering.

In particular, the present invention is concerned with bonding two metallic surfaces together by coating each of the metallic surfaces with a layer of a first material followed by a layer of a second and different material. The second and different material contacts the layer of the first material and the first material and second and different material must be from a binary system (binary system refers to employing pure metals and/or alloys) containing a eutectic reaction such as Pb-Sn or Sn-Bi. The layers of the second and different material of each of the metallic substrates are abutted together and then the layers are heated above the eutectic temperature of the materials to form a localized liquid, which upon solidification, results in an interconnection between two surfaces.
- Figure 1a: schematically illustrates the use of an Sn-coated top (on Pb-rich) insert layer sandwiched between two Sn-coated copper surface pads in accordance with the present invention.
- Figure 1b: schematically illustrates a multi-layer structure on each of the mating surfaces in accordance with the present invention.
- Figures 2a-2e: schematically illustrate compositional and phase changes that occur during the bonding process for a representative eutectic system (Pb-Sn) employed in the method of the present invention.
- Figure 3: is a schematic of apparatus suitable for carrying out the process of the present invention.

The method of the present invention is especially applicable to bonding those metallic substrates which normally require a soldering technique and especially metallic surfaces employed in high-quality electronic devices such as copper surfaces including copper bonding pads in, for example, mounting electronic components, such as flexible thin film carriers, to printed circuit cards or boards.

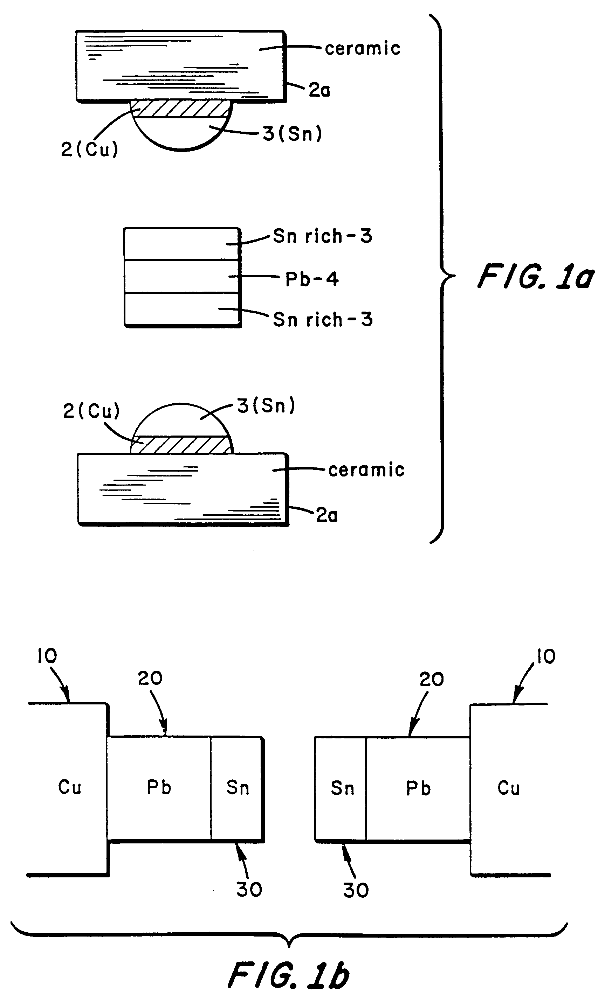

In order to facilitate understanding of the present invention, reference is made to Figure 1b and the use of lead and tin layers as preferred materials to form the eutectic. In particular, numeral 10 refers to the metallic substrate, such as copper, to be bonded. Deposited onto each of the layers (10) is a layer (20) of a first material such as Pb or a Pb-rich Pb-Sn alloy. Typical thicknesses of layer (20) are about 50 µm (0.002") to about 250 µm (0.010"). Typically, this deposited layer is an alloy of Pb (2-5%)Sn.

Deposited on each layer (20) is a layer of a second and different material (30). In the preferred aspects of the present invention layer (30) is tin. The first material and the second and different material of the layers are chosen so that a eutectic liquid layer will form at the interface between both layers. Layer (30) is generally not as thick as layer (20) and is usually about 25 µm (0.001") to about 50 µm (0.002") thick. Typically, this layer (30) is pure Sn having a thickness of about 38 µm (0.0015"). Of course, these relative thicknesses depend on the eutectic composition of the particular system employed, keeping in mind that pure metals are not required; the composition of the deposits and the desired final composition. In the preferred embodiment of employing a tin layer deposited on a lead layer, the tin layer should be deposited immediately after the lead deposition before the lead can undergo significant oxidation.

The layers (30) of the second and different material on each of the metallic surfaces are abutted together and then the composite is heated to a temperature above the eutectic temperature. In the case of the lead-tin eutectic, a temperature of about 183.5°C to about 210°C is usually employed. Heating at these temperatures results in interdiffusion between the material of layer (30) and that of layer (20) beginning at both of the interfaces between layers (20) and (30). Interdiffusion between the exterior layers (30) is not required.

During bonding a small amount of pressure is applied to crack the surface Sn-oxide. As the material of layers (20) and (30) interdiffuse within each layer, the two liquid zones grow outward, thereby consuming the material in layer (30) which, in most cases, is Sn. Moreover, surface tension of the two liquid zones tends to pull the individual layers together (through the cracked Sn-oxide layer) and disperse the oxides throughout the molten zones. The use of either mechanical pressure and/or ultrasonic energy during the bonding process will enable any oxide layer, on the top surface of layers (30), to crack and allow the liquid to completely wet both of the bonding sites. The applied load can be as low as 7.8 gm/mm² per pad area.

Use of multiple layers of different materials pursuant to the present invention provides an advantage in that the materials and relative thicknesses of such can be selected so that the liquid zone is self-limiting. For instance, in the lead-tin system, the relative thickness of the tin layer can be such that complete homogenization of the two layers will produce a lead-rich alloy. As the liquid zone grows outward, the lead content of the liquid will increase and this lead enrichment will progress until the liquid composition is outside the eutectic liquid range. At this point, the liquid will then solidify. This is advantageous since the solidification can be accomplished before any of the liquid actually contacts the copper substrates, thereby preventing the formation of excessive copper-tin intermetallic phases.

The process of liquid phase formation and the resolidification can occur at a constant temperature or temperature range above the eutectic temperature. This temperature can be as low as 0.5°C above the eutectic temperature as was found to be the case in the Sn-Pb system.

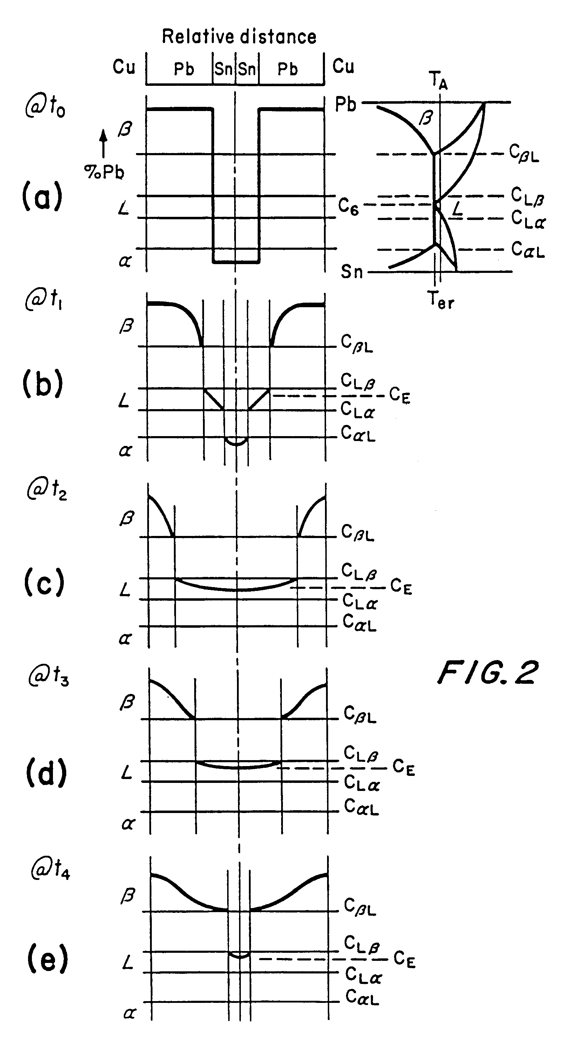

Reference to Figures 2a to 2e schematically illustrates the various compositional and phase changes that occurred during the isothermal bonding process. In particular, the percent lead is plotted as a function of distance for increasing time (t). The tin-rich and lead-rich phases are designated as α and β respectively. The equilibrium compositions at the liquid-solid boundaries are determined by the bonding temperature T_{B}) and the equilibrium phase diagram. The stable phase regions are labelled along the left side on the composition axis.

In particular, the initial condition (t₀) (see Figure 2a) consists of lead-rich layers beneath the two contacting tin-rich layers. At time (t₁) (see Figure 2b) interdiffusion has created two liquid zones at the lead/tin boundaries. These grow rapidly outward to consume the original bonding interface at time (t₂) (see Figure 2c). The lead continues to diffuse into the liquid zone at time (t₃) (see Figure 2d) making it unstable. The liquid zone continues to shrink at time t₄) (see Figure 2e) until complete solidification occurs.

Without further homogenization, the final composition profile will contain outer layers near the composition of the initial lead layer and an inner region near the solidus composition. All of the regions will be in the high fatigue-resistant, lead-rich composition range.

Although the above method has been described with specific reference to a lead-tin eutectic system, such is just as applicable to other eutectic systems such as tin-bismuth or tin-indium.

Furthermore, as discussed above, the present invention is especially beneficial in first level electronic packaging for attaching integrated circuit chips to integrated circuit chip carriers.

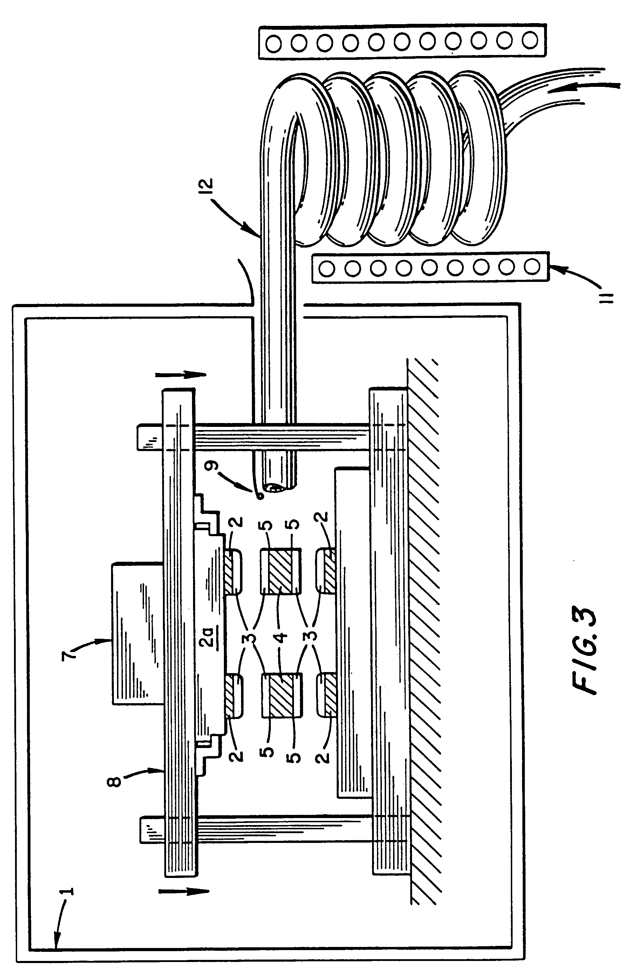

Reference to Figure 3 shows a schematic of apparatus that can be used to carry out the process of the present invention. This Figure illustrates the use of a multilayered structure shown, for instance, in Figure 1a. Numeral 1 represents a chamber that can be placed under vacuum. Numeral 2 refers to the metal structures such as copper on a ceramic substrate (2a) (see Figure 1a) that are to be bonded together. Numerals 3 and 4 refer to the different layers such as tin and lead, respectively, that form the eutectic liquid layer at the interface 5 between them. Numeral 7 represents a weight to insure intimate contact between the abutting surfaces. Numeral 8 represents a holding device for maintaining the metal structures during the processing. Numeral 9 represents a thermocouple to determine the temperature of the gas flowing through conduit 12. Numeral 11 represents furnace means for heating the gas flowing through conduit 12. This apparatus can, of course, also be used to allow TLP bonding of an initial multilayered structure shown in Figure 1b or any of the structures within the scope of the present invention.

The following non-limiting example is presented to further illustrate the present invention:
The multilayered structure illustrated in Figure 3 wherein a tinned piece of lead is sandwiched between tin coated copper rods is subjected to an inert gas reflow method in apparatus of the type shown in Figure 3. A force of about 69 KN/m² (10 psi) (per pad area) (7) is used to insure intimate contact between the abutting surfaces. The thickness of the lead button (4) prior to tinning is about 0.5 mm thick. The tin coating (3) on the lead button and the copper rods is obtained by dipping in a molten tin bath. The chamber is evacuated to about 106.6 KPa (800 mm Hg). The structure can then be reflowed in an inert gas or a reducing atmosphere (argon + 4% H₂) at a temperature ranging from 183.5°C to the melting temperature of pure Sn.

## Claims

1. A method for bonding two metallic surfaces together which comprises:
a) coating each of said metallic surfaces (10) with a layer (20) of a first material and on top of said layer (20) with a layer (30) of second and different material contacting said layer of said first material; wherein the first material and second and different material are from a binary system of metals or alloys containing a eutectic reaction;
b) abutting the layer of the second and different material of each of said metallic surfaces together;
c) then heating the layers above the eutectic temperature of the materials to thereby form a localized liquid which consumes the interface between the second and different materials, which then solidifies, resulting in an interconnection between the surfaces.

2. The method of claim 1 wherein said metallic surfaces are copper.

3. The method of claims 1 or 2 wherein said first material includes lead or a lead rich Pb-Sn alloy, preferably an alloy of Pb-(2-5%)Sn.

4. The method of one of the preceding claims wherein said second and different material includes tin.

5. The method of claim 4 wherein said heating is to temperature of about 183.5°C to a temperature slightly below the melting temperature of pure Sn, preferably to about 210°C.

6. The method of one of the preceding claims wherein the thickness of said layer (30) of second and different material is thinner than the thickness of said layer (20) of said first material.

7. The method of one of the preceding claims wherein the thickness of said layer (20) of a first material is about 50 µm (0.002") to about 250 µm (0.010") and the thickness of said second layer (30) of a second and different material is about 25 µm (0.001") to about 50 µm (0.002").

8. The method of one of the preceding claims wherein the layers are abutted under pressure to enhance the dispersion of interfacial Sn oxides.

9. The method of one of the preceding claims where ultrasonic vibrations are supplied to the structure during reflow to enhance oxide dispersion.

10. The method of one of the preceding claims wherein said layer of second and different material is deposited immediately after coating the metallic surfaces with the layer of first material.

## Patentansprüche

1. Verfahren zum Verbinden zweier metallischer Oberflächen, das folgendes umfaßt:
a) Beschichten jeder der metallischen Oberflächen (10) mit einer Schicht (20) aus einem ersten Material und Beschichten der Schicht (20) mit einer Schicht (30) aus einem zweiten, anderen Material, die die Schicht aus dem ersten Material berührt, wobei das erste Material und das zweite, andere Material aus einem binären Metall- oder Legierungssystem sind, das ein eutektisches Verhalten aufweist;
b) Zusammenbringen der Schicht aus dem zweiten, anderen Material mit jeder der metallischen Oberflächen;
c) dann Erhitzen der Schichten über die Eutektikumstemperatur der Materialien, um dadurch eine lokalisierte Flüssigkeit zu bilden, die die Grenzschicht zwischen den zweiten, anderen Materialien verbraucht, und die dann erstarrt, wobei eine Verbindung zwischen den Oberflächen entsteht.

2. Verfahren gemäß Anspruch 1, wobei die metallischen Oberflächen Kupfer sind.

3. Verfahren gemäß Anspruch 1 oder 2, wobei das erste Material Blei oder eine bleireiche Pb-Sn-Legierung, vorzugsweise eine Legierung aus Pb-(2-5%)Sn, enthält.

4. Verfahren gemäß einem der vorhergehenden Ansprüche, wobei das zweite, andere Material Zinn enthält.

5. Verfahren gemäß Anspruch 4, wobei das Erhitzen auf eine Temperatur zwischen etwa 183,5°C und einer Temperatur etwas unterhalb der Schmelztemperatur von reinem Zinn, vorzugsweise auf etwa 210°C, erfolgt.

6. Verfahren gemäß einem der vorhergehenden Ansprüche, wobei die Dicke der Schicht (30) aus dem zweiten, anderen Material kleiner als die Dicke der Schicht (20) aus dem ersten Material ist.

7. Verfahren gemäß einem der vorhergehenden Ansprüche, wobei die Dicke der Schicht (20) aus einem ersten Material zwischen etwa 50 µm (0,002") und etwa 250 µm (0,010") und die Dicke der zweiten Schicht (30) aus einem zweiten, anderen Material zwischen etwa 25 µm (0,001") und etwa 50 µm (0,002") liegt.

8. Verfahren gemäß einem der vorhergehenden Ansprüche, wobei die Schichten unter Druck zusammengefügt werden, um die Verteilung von Sn-Oxiden auf der Grenzfläche zu verbessern.

9. Verfahren gemäß einem der vorhergehenden Ansprüche, wobei der Aufbau während des Schmelzens Ultraschallschwingungen ausgesetzt wird, um die Verteilung des Oxids zu verbessern.

10. Verfahren gemäß einem der vorhergehenden Ansprüche, wobei die Schicht aus dem zweiten, anderen Material unmittelbar nach Beschichten der Oberflächen mit der Schicht aus dem ersten Material aufgebracht wird.

## Revendications

1. Procédé pour souder deux surfaces métalliques l'une à l'autre, comprenant les étapes suivantes consistant à:
a) enduire chacune des dites surfaces métalliques (10) avec une couche (20) d'un premier matériau et, sur ladite couche (20), avec une couche (30) d'un second matériau différent contactant ladite couche du dit premier matériau; caractérisé en ce que le premier matériau et le second matériau différent proviennent d'un système binaire de métaux ou d'alliages contenant une réaction eutectique;
b) abouter les couches de second matériau différent de chacune des dites surfaces métalliques l'une à l'autre;
c) puis, chauffer les couches au-dessus de la température d'eutéxie des matériaux pour former, ainsi, une zone liquide localisée qui absorbe l'interface entre les seconds matériaux différents, qui se solidifie ensuite pour former une interconnexion entre les surfaces.

2. Procédé selon la revendication 1, dans lequel les dites surfaces métalliques sont en cuivre.

3. Procédé selon la revendication 1 ou 2, dans lequel ledit premier matériau comprend du plomb ou un alliage de Pb-Sn riche en plomb - de préférence, un alliage de Pb-(2-5%)Sn.

4. Procédé selon l'une quelconque des revendications précédentes, dans lequel ledit second matériau différent comprend de l'étain.

5. Procédé selon la revendication 4, dans lequel la température de réchauffement est comprise entre 183,5°C et une température légèrement inférieure à la température de fusion du Sn pur, et est de préférence égale à 210°C.

6. Procédé selon l'une des revendications précédentes, dans lequel l'épaisseur de ladite couche (30) du second matériau différent est moins épaisse que ladite couche (20) du dit premier matériau.

7. Procédé selon l'une des revendications précédentes, dans lequel l'épaisseur de ladite couche (20) d'un premier matériau est comprise entre 50 µm (0.002") et 250 µm (0.010"), et l'épaisseur de ladite seconde couche (30) d'un second matériau différent est comprise entre 25 µm (0.001") et 50 µm (0.002").

8. Procédé selon l'une des revendications précédentes, dans lequel les dites couches sont aboutées l'une à l'autre pour accélérer la dispersion des oxydes-Sn d'interface.

9. Procédé selon l'une des revendications précédentes, dans lequel des vibrations ultrasonores sont appliquées à la structure au cours de la refusion pour accélérer la dispersion des oxydes.

10. Procédé selon l'une des revendications précédentes, dans lequel ladite couche du second matériau différent est déposée immédiatement après le dépôt de ladite couche du premier matériau sur les surfaces métalliques.
